# EUROPEAN PATENT APPLICATION

(11) **EP 1 564 027 A1**
(43) Date of publication of application: **17.08.2005**
(21) Application number: 04380024.2
(22) Date of filing: 06.02.2004
(51) Int. Cl.: B44D 5/00, B44C 1/04, B05D 5/00

(54) **Procedure for decorating pieces of pottery and similar**

(71) Applicant: Estudio Ceramico, S.L., 12130 San Juan de Moro, (Castellon) (ES)
(72) Inventor: Rivas Ramos, José Miguel, 12130 San Juan de Moro (Castellon) (ES)
(74) Representative: Canadell Isern, Roberto

(57) **Abstract**

The purpose of this Patent is a "Procedure for decorating pieces of pottery and similar" the use of which is explained in the title of the invention.

The procedure is comprised of the following operations:
Previous superficial treatment (1) of the pieces by any known procedure (enamelling, serigraphy) to provide them with chromatic variety.
Application of removable adhesive material (2) with the shape of the chosen decorative motifs ("mask").
Physical depositing of metallic salt vapors or metals (PVD) on the entire surface (3) of the piece, including the mask.

Manual or automatic removal of the mask partially revealing the treated surface (enamelled or serigraphed) of the piece with the shape of the decorative motifs and the chromatic variety of the previously carried out superficial treatment.

## Description

### PURPOSE

The purpose to which the invention protected by this Patent refers is a "Procedure for decorating pieces of pottery and similar".

Although the claimed procedure is designed to be preferentially applied to pottery, said application can be extended, without varying the operation, to other materials of similar use, for example, glass or even certain plastic materials.

### HISTORY

There is knowledge, within the technology of decorating pieces of pottery, of the procedure of physically depositing metallic salt vapors of copper, manganese or others on the surface of said pieces of pottery, giving them a uniform and shiny appearance, with different tones depending on the nature and proportion of the salts used.

However, the application of said procedure, synthetically represented by the initials of its denomination in P.V.D. English, requires complete and uniform depositing of the metal on the surface of the piece of pottery, which results in a certain soberness in the aspect, a chromatic limitation and a monotony more than noticeable as the surface covered by pieces of pottery treated according to the P.V.D. becomes larger.

### DESCRIPTION OF THE INVENTION

The purpose of the invention constituting the object of this Patent is to overcome the apparent inconveniences arising from the known PVD procedure described above, and said invention has been specifically designed and developed bearing in mind this priority objective.

The claimed procedure is preferably applicable to pieces of pottery with the widest variety of characteristics, both during the process of obtention (mono-baking, bi-baking, third baking) and the previous superficial treatment (enamelling, bracketing, serigraphing) or the shape (pieces, friezes, frames, etc.).

In any case, the purpose of the procedure is, as indicated in the title, superficial decoration of the pieces on which it is applied, creating freely chosen decorative motifs but in a size, shape and representation suitable to the shape of the piece it is intended to decorate.

The procedure includes the following operations:
Previous superficial treatment of the pieces by any known procedure (enamelling, serigraphy) to provide them with a chromatic variety.
Application of removable adhesive material with the shape of the chosen decorative motifs ("mask").
Physical depositing of metallic or metal salt vapor (PVD) on the entire surface of the piece, including the mask.
Removal of the mask either manually or automatically, partially revealing the treated surface (enamelled or serigraphed) of the piece with the shape of the decorative motifs and the chromatic variety arising from the previously carried out superficial treatment.

### BRIEF DESCRIPTION OF THE DRAWINGS

In order to complement the description of the invention and to facilitate interpretation of the functional characteristics of its purpose, enclosed are drawings in which the results applying the claimed procedure on pottery of various shapes are represented. In said drawings:

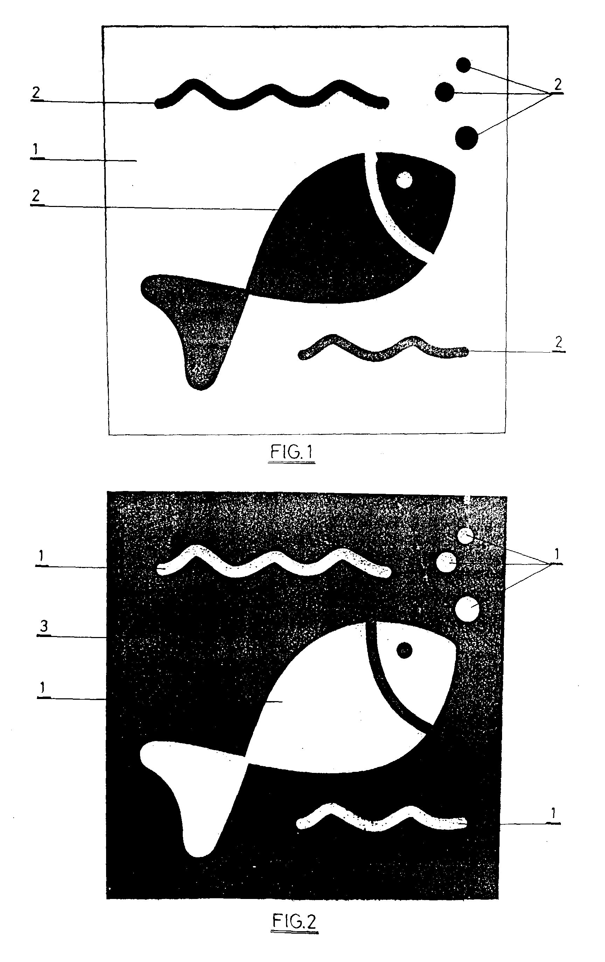

Figure 1 represents a piece of square pottery (piece) on the previously treated surface of which masks corresponding to the chosen decorative motifs have been adhered.
Figure 2 corresponds to the same piece as Figure 1 in which the claimed procedure has been completed by physically depositing the metallic salts in a uniform way and removing the masks to reveal the chromatic base.

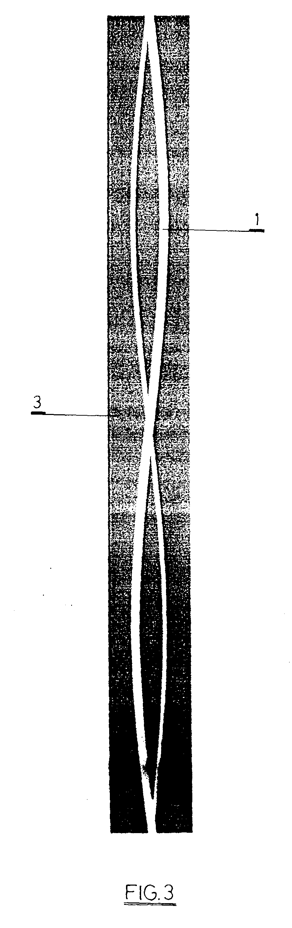

Figure 3 shows the aspect of the decoration of narrow and long ceramic pieces with formally ideal motifs.

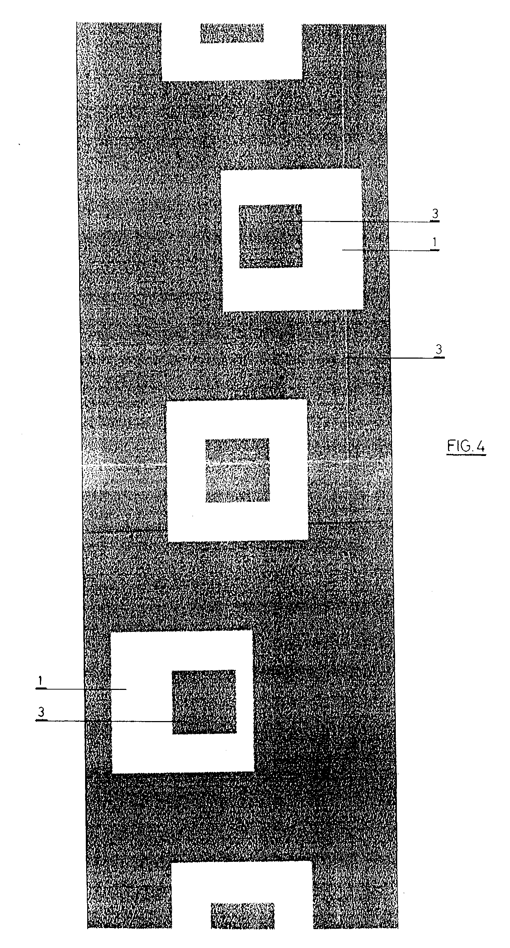

Figure 4 represents a flat frieze with decoration obtained by applying the claimed procedure.

### DESCRIPTION OF A PREFERRED PERFORMANCE

In order to clearly show the nature and scope of the advantageous application of the "Procedure for decorating pieces of pottery and similar", constituting the purpose of the claimed invention, the following is a description of the operations constituting the procedure and the sequence of its performance, which is the same as described, making reference to the drawings that, on representing a preferred performance of said object in an informative way, should be considered in the widest sense and not limiting of the application and the content of the claimed invention.

The procedure is made up of the following operations:
Previous superficial treatment (1) of the pieces by any known procedure (enamelling, serigraphy) to provide them with chromatic variety.
Application of removable adhesive material (2) with the shape of the chosen decorative motifs ("mask").
Physical depositing of metallic salt vapors or metals (PVD) on the entire surface (3) of the piece, including the mask.
Manual or automatic removal of the mask partially revealing the treated surface (1) (enamelled or serigraphed) of the piece with the shape of the decorative motifs and the chromatic variety of the previously carried out superficial treatment.

## Claims

1. Procedure for decorating pieces of pottery and similar, **characterized by** the fact it is comprised of the following operations performed in the same sequence as they are described:
Previous superficial treatment (1) of the pieces by any known procedure (enamelling, serigraphy) to provide them with chromatic variety.
Application of removable adhesive material (2) with the shape of the chosen decorative motifs ("mask").
Physical depositing of metallic salt vapors or metals (PVD) on the entire surface (3) of the piece, including the mask.
Manual or automatic removal of the mask partially revealing the treated surface (enamelled or serigraphed) of the piece with the shape of the decorative motifs and the chromatic variety of the previously carried out superficial treatment.
